(19) 

**Europäisches Patentamt**
**European Patent Office**
**Office européen des brevets**

(11) **EP 2 267 885 A1**

(12) **EUROPEAN PATENT APPLICATION**

(43) Date of publication:
**29.12.2010 Bulletin 2010/52**

(51) Int Cl.:
**H03F 1/02** *(2006.01)*

(21) Application number: **09162964.2**

(22) Date of filing: **17.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **NXP B.V.**
**5656 AG Eindhoven (NL)**

(72) Inventor: **Blednov, Igor**
**Redhill, Surrey RH1 1DL (GB)**

(74) Representative: **Hardingham, Christopher Mark**
**NXP Semiconductors (UK) Ltd.**
**Betchworth House**
**57-65 Station Road**
**Redhill, Surrey RH1 1DL (GB)**

(54) **Doherty amplifier**

(57) An amplifier system and method comprising: a main amplifier (22); a peak amplifier (24); wherein the main amplifier (22) is adapted to output an amplified signal (30); the main amplifier (22) is powered by a variable supply voltage (35); the main amplifier (22) comprises an inductor (40) and a capacitor (42) connected in series; the inductor (40) is connected to earth via the capacitor (42); and the variable supply voltage (35) is connected to the main amplifier output signal (30) via the inductor (40). The variable supply voltage (35) may be the amplified envelope of a replica of a first input signal (21). The inductor (40) and the capacitor (42) may be arranged in parallel to the main amplifier output signal (30). A supply modulator (26) and the capacitor (42) may be arranged on the same die.

FIG. 2

**Description**

The present invention relates to a Doherty type amplifier and a method of amplifying an input signal of such a Doherty type amplifier.

The classical Doherty amplifier, first suggested by W. Doherty in 1936, was originally intended for use in low to medium frequency amplitude modulated broadcasting transmitters.

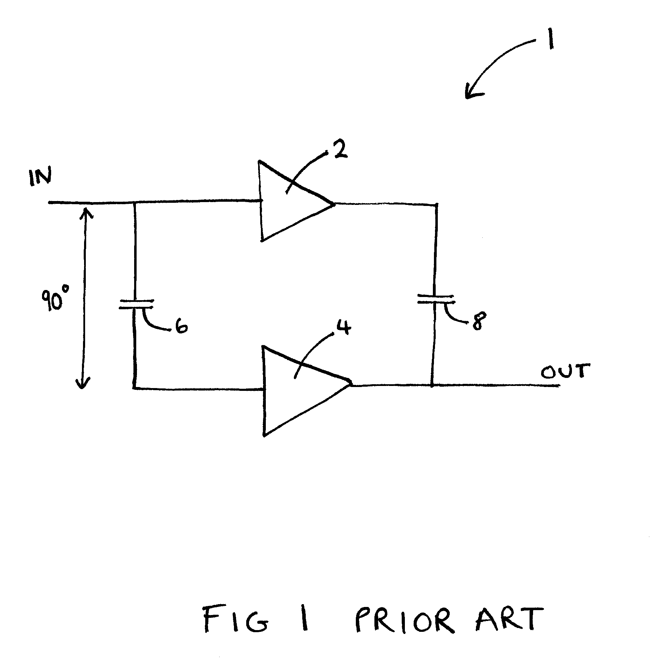

Figure 1 is a schematic illustration of a classic Doherty amplifier 1. The classic Doherty amplifier comprises a first power amplifier 2, a second power amplifier 4, a capacitor 6 and a further capacitor 8. The first power amplifier 2 is referred to as the Main power amplifier. The second power amplifier 4 is referred to as the Peak power amplifier.

The classical or symmetrical Doherty amplifier can provide an improved efficiency in a power range of 6dB below the peak power level. However, this 6dB range is not sufficient for modern communication systems using modulation signals, in which this power range can be as large as 12dB - 20dB.

The classical Doherty amplifier can be modified and updated to increase the efficiency of high frequency power amplifiers. Frederick H. Raab "EFFICIENCY OF DOHERTY RF POWER-AMPLIFIER SYSTEMS", IEEE TRANSACTIONS ON BROADCASTING, Vol. BC-33, No. 3, September 1987 describes how the power range of Doherty amplifier exhibiting improved efficiency can be increased from 6dB to 12dB by the use of two different approaches: asymmetrical Doherty amplifiers and 3-Way Doherty amplifiers.

Asymmetrical Doherty amplifiers use larger Peak amplifiers than Main amplifiers. The bigger the difference in power capability between the amplifiers, the larger the power range of improved efficiency that can be achieved. However, the linearity of such an asymmetrical Doherty amplifier is degraded, mainly due to non-smooth AM-PM characteristic. Practically, a power range up to 10dB may be achieved with this approach, but it is not enough for modern communication systems.

3-Way Doherty amplifiers can provide a power range of up to 12 dB with improved efficiency. However, the development and linearity control of such amplifiers is difficult as more components are necessary and need to be handled properly. Also, a power range of up to 12 dB power range may still not be sufficient for modern and future communication systems. Also, linearity degradation in 3-way Doherty amplifiers becomes a major problem when operating in a range 6dB below peak power level. This is due to the fact that the Main amplifier sees very high impedance at its output in this power range, in which the second (Peak) amplifier becomes active and a second inversion of impedance takes place at the output of the first (Main) amplifier. Load impedance at the output of the Main amplifier starts to increase while the input power level also increases. This leads to an output current limitation of the Main amplifier, a drop in power contributed by the Main amplifier to the overall Doherty amplifier output, and growth of inter-modulation products (IMD) at the output.

A further disadvantage of many current Doherty amplifiers is an increased level of 'Electrical Memory Effects'. These tend to be caused by a supply voltage drop due to an input signal surge and sudden high current consumption by the Main and Peak amplifiers. Electrical Memory effects may be qualified as non-linear distortions added to the output signal of the Doherty amplifier caused by parasitic modulation of power supply voltage. They are mainly caused by the variable amplitude of the amplified signal and the non-ideality of the power supply network.

Abrupt increases in current supplied to the amplifier cause a drop of supply voltage. The drop of supply voltage begins with the current surge and stays for a period of time after the current surge has gone. This effect looks like a short "memory" of the circuit about a previous event, such as current consumption surge.

The drop of the voltage of supply is caused by "choke" or inductance connecting the amplifier output, device drain, or collector, to the closest capacitor of power supply network. This inductance is required for preventing the RF output power loss through output RF signal leakage to DC power supply network. This network creates a Low-Pass filter, which rejects or isolates the high frequency signal from DC supply network. The higher inductance value, the better isolation and less output power losses take place at output of RF power device. However, the current supply to the Main and Peak device or amplifier is slowed down by this inductance during fast growth of the output RF signal envelope. This slow-down creates DC supply voltage drops at the outputs of the Main and Peak amplifiers causing Electrical Memory Effects resulting in additional signal distortions.

A further disadvantage of many current Doherty amplifiers is the effect of 'Temperature Memory Effects', which are the results of distortions of the output current signal wave at peaks of the signal. DC power dissipation on a device is maximal during peak current delivery and, for a short time, the temperature of the device rises. This also affects the peak current capability of the amplifiers and lasts for some time after signal peak has gone. The result of this is a delayed distortion of the signal amplified afterwards.

A known amplifier design that may be used to increase efficiency is that of the dynamic supply design. The purpose of a dynamic supply is to create a time-varying supply voltage for a linear power amplifier which in general follows the amplitude of modulation of input signal. This technique is frequently called envelope tracking because the power supply creates a voltage that is referenced to the envelope voltage. However, this approach suffers from the memory effects as described above due to the fact that high power devices are used in Doherty amplifiers, which have to be connected to a power supply through relatively large inductance.

US 7,330,071 discloses a system and method for efficiently amplifying a radio frequency signal. In general, the system includes power amplifier circuitry that efficiently amplifies an input signal under power back-off conditions. In one embodiment, the power amplifier circuitry has at least 30% at a 6dB back-off point.

WO/2007/119208 discloses an integrated Doherty amplifier structure comprising an input bond pad and an output bond pad. However, the system proposed by WO/2007/119208 requires an external power supply unit to work and the system will only work in the case of low power devices.

The paper "Optimized Envelope Tracking Operation of Doherty Power Amplifier for High Efficiency Over an Extended Dynamic Range", J. Choi, D. Kang, D. Kim, and B. Kim, IEEE Transactions on Microwave Theory and Techniques, 2009, discloses an envelope tracking operation wherein modulating the supply voltage of the carrier amplifier provides that the supply modulator provides half of the current for the same power amplifier output power.

The present inventors have realised it would be desirable to provide an extended power range with high efficiency for Doherty amplifiers operating at high power.

The present inventors have further realised it would be desirable to overcome the high electrical memory effect exhibited by current Doherty amplifiers operating at high power.

The present inventors have realised it would be desirable to reduce the negative effects of abrupt increases in current supplied to the amplifier.

The present inventors have further realised it would be desirable to correct High Temperature Memory Effects that arise due to the variation in temperature in the die of the amplifier in respect to the amplifier output.

In a first aspect, the present invention provides an amplifier system comprising: a main amplifier; a peak amplifier; wherein the main amplifier is adapted to output an amplified signal; the main amplifier is powered by a variable supply voltage; the main amplifier comprises an inductor and a capacitor connected in series; the inductor is connected to earth via the capacitor; and the variable supply voltage is connected to the main amplifier output signal via the inductor.

The system may further comprise a supply modulator; wherein the variable supply voltage is the output from the supply modulator; the amplifier system is adapted to receive a first input signal; the supply modulator is adapted to receive a second input signal; and the second input signal is the envelope of a replica of the first input signal.

The variable supply voltage may be the amplified envelope of a replica of the first input signal.

The inductor and the capacitor may be arranged in parallel to the main amplifier output signal.

The supply modulator and the capacitor may be arranged on the same die.

The supply modulator may be an HBT switching device.

The peak amplifier may be adapted to output an amplified signal; and the amplifier system may be adapted to combine the main amplifier output signal and the peak amplifier output signal.

In a further aspect, the present invention provides a method of modifying a signal comprising the steps of: splitting the input signal into a first component signal and a second component signal; amplifying the first component signal with a main amplifier; and amplifying the second component signal with a peak amplifier; wherein the main amplifier is adapted to output an amplified signal; the main amplifier is powered by a variable supply voltage; the main amplifier comprises an inductor and a capacitor connected in series; the inductor is connected to earth via the capacitor; and the variable supply voltage is connected to the main amplifier output signal via the inductor.

The method may further comprise the steps of: delaying the second component signal; delaying the amplified first component signal; and recombining the delayed amplified first component signal and the amplified second component signal.

The variable supply voltage may be the output from a supply modulator; and the variable supply voltage may be the amplified envelope of a replica of the first input signal.

The inductor and the capacitor may be arranged in parallel to the main amplifier output signal.

The supply modulator and the capacitor may be arranged on the same die.

The supply modulator may be an HBT switching device.

The peak amplifier may output an amplified signal; and the main amplifier output signal and the peak amplifier output signal are combined.

Embodiments of the present invention will now be described, by way of example, with reference to the accompanying drawings, in which:

Figure 1 is a schematic illustration (not to scale) of classic Doherty amplifier;
Figure 2 is a schematic illustration (not to scale) of a modified Doherty amplifier according to a first embodiment of the invention;
Figure 3 is a process flow chart showing certain process steps carried out in one embodiment of a process for modifying an input signal using the modified Doherty amplifier described in Figure 2; and
Figure 4 is a schematic illustration of the modified Doherty amplifier of Figure 2 shown in greater detail.

The embodiments described below comprise a modified Doherty amplifier and a method of modifying a signal.

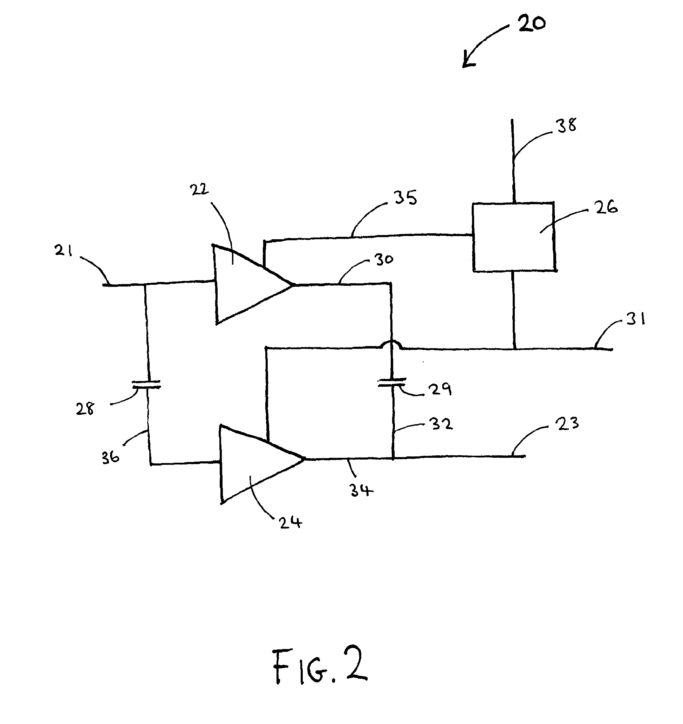

Figure 2 is a schematic illustration (not to scale) of a modified Doherty amplifier 20 according to a first embodiment of the invention. The modified Doherty amplifier comprises a Main amplifier 22, a Peak amplifier 24, a supply modulator 26, a first capacitor 28 and a second capacitor 29.

The Main amplifier 22 receives an input signal 21. The input signal 21 is an RF signal. The input signal 21 changes in time according to a modulation signal. In this embodiment, the input signal occupies a frequency band of up to 100MHz.

The Main amplifier 22 is powered by a modulator output 35. The Main amplifier 22 outputs a first output signal 30. The first output signal 30 is received by a second capacitor 29. In this embodiment, the second capacitor 29 provides a phase shift of the first output signal. Also, in this embodiment, the second capacitor 29 provides an impedance transformation, and a phase shift of the first output 30 signal by 90 degrees. It will be appreciated that the input network of the Doherty amplifier may be implemented in a number of different ways, not limited to or by the specific input network described herein.

The Peak amplifier 24 receives a delayed input signal 36 from a first capacitor 28. The first capacitor 28 receives the input signal 21. The first capacitor 28 delays the input signal 21. In this example, the first capacitor 28 delays the input signal 21 by 90 degrees. The Peak amplifier 24 is powered by a power supply 31. The power supply 31 is non-variable DC supply voltage. The Peak amplifier 24 outputs a second output signal 34.

The modified Doherty amplifier 20 outputs an amplifier output signal 23. The amplifier output signal 23 is the sum of the first delayed output signal 32 and the second output signal 34. The amplifier output signal 23 is an RF signal.

In this embodiment, the supply modulator 26 is a HBT switching device. However, in other embodiments, the supply modulator 26 is a different appropriate device, for example, a BJT, an FET or a MOS switching device. The supply modulator 26 provides minimal resistance between the power supply 31 and the modulator output 35 when it is ON and high resistance when it is OFF. The supply modulator 26 receives a modulator input signal 38. In this embodiment, the modulator input signal 38 is a replica of the envelope of the input signal 21. However, in other embodiments the modulator input signal 38 is a different appropriate signal, for example a replica of the modulation signal of the input signal 21. The supply modulator 26 is powered by the power supply 31. The supply modulator outputs the modulator output 35. The modulator output 35 is a variable DC supply voltage. The modulator output 35 is a signal comprising short pulses of constant length. The frequency of the short pulses of the modulator output 35 is proportional to the amplitude of the envelope of the input signal 21. The minimum frequency of the pulses is greater than twice the maximum frequency of the modulation signal spectrum. The input signal 21 is split between and drives the Main and Peak amplifiers 22,24. The input signal 21 is split between the Main and Peak amplifiers 22, 24 unequally.

An unequal input power division ratio between first (Main) and second (Peak) amplifiers devices is needed for two reasons. Firstly, it is required due to the fact that generally C-class operation of any power amplifier demonstrates maximum power gain 3dB - 6dB lower than AB-class operation of a power amplifier. In a conventional Doherty amplifier, both Main and Peak amplifiers deliver equal peak power at peak power of Doherty amplifier. Thus, the input power difference between the Main and Peak amplifiers, i.e. the power division ratio, is equal to the peak power gain difference between A Main amplifier (operating in AB-class) and Peak amplifier (operating in C-class). Secondly, C-class operation tends to have a wide operation mode range related to the bias condition.

In this embodiment, the power division ratio is a function of gate bias of the Peak amplifier. The peak power gain of the supply modulator 26 depends on the gate bias and the real part of input impedance. The gain difference between the Main and Peak amplifiers is expressed below in equation 1. In this embodiment, the power division ratio is given by equation 1:

$$\frac{P_{In\_peak}}{P_{In\_main}} = \frac{(\sqrt{2}V_{gs\_RF\max} - V_{gs\_bias\_peak})^2 \, \text{Re}/Z_{In\_peak}}{(\sqrt{2}V_{gs\_RF\max} - V_{gs\_bias\_main})^2 \, \text{Re}/Z_{In\_main}} \quad (1)$$

where: $P_{In\_peak}$ is the input power of the peak amplifier;

$P_{In\_main}$ is the input power of the main amplifier;

$Vg_{s\_RFmax}$ is the voltage magnitude of the input signal across gate-source capacitor of the supply modulator 26 at maximum power output;

$V_{gs\_bias\_peak/main}$ is the voltage of the supply modulator 26 gate DC bias;

$Re/Z_{In-main/peak}$ is the real part of input impedance of the supply modulator 26 at operational frequency at peak power level;

In other embodiments, a different input power division is used required, for example, as required by use of an asymmetrical Doherty system. In other embodiments, the additional difference in power is equal to the difference in size between the Main and Peak amplifiers. Thus, in other embodiments the input power difference or ratio is given by equation 2 below:

$$\Delta P_{In\_(dB)} = 10\log\left( \frac{(\sqrt{2}V_{gs\_RF\max} - V_{gs\_bias\_peak})^2 \operatorname{Re}/Z_{In\_peak}}{(\sqrt{2}V_{gs\_RF\max} - V_{gs\_bias\_main})^2 \operatorname{Re}/Z_{In\_main}} x \frac{W_{g\_peak}}{W_{g\_main}} \right) \quad (2)$$

where: $\Delta P_{In\_(dB)}$ is the input power difference or ratio; and
$W_{g\_peak/main}$ is the gate width of the peak/main amplifier.

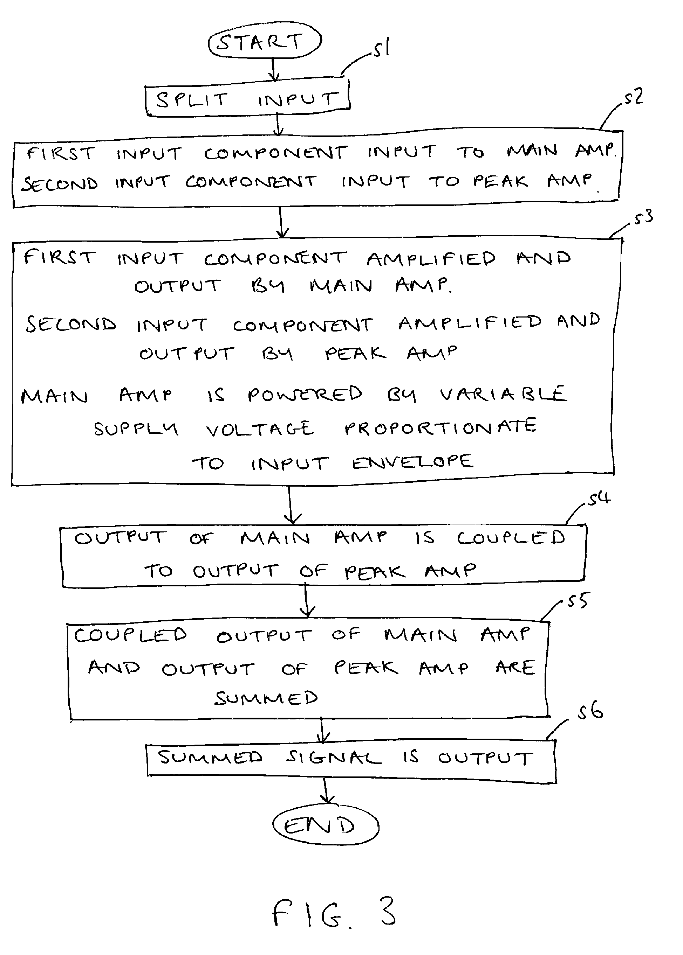

Figure 3 is a process flow chart showing certain process steps carried out in one embodiment of a process for modifying an input signal 21 using the above described Doherty amplifier 20.

At step s1, an input signal 21 is split into unequal first and second component parts. In this embodiment, the input signal 21 is split into the first and second parts according to equation 1 above. However, in other embodiments the input signal 21 is split into the first and second parts according to a different criteria, for example, equation 2.

At step s2, in this embodiment, the first component part of the input signal 21 is input into the Main amplifier 22 of the modified Doherty amplifier 20. The second component part of the input signal 21 is coupled, using a first capacitor 28, to the Peak amplifier 24 of the modified Doherty amplifier 20. However, in other embodiments the first and second component parts of the input signal 21 are input differently, for example, in other embodiments the first component part is input into the Peak amplifier 24 and the second component part is input into to the Main amplifier 22.

At step s3, the first component part of the input signal 21 is amplified by the Main amplifier 22. The Main amplifier 22 is powered by a variable DC supply voltage proportional to the amplitude of the envelope of the input signal 21 from a supply modulator 26. The second component of the input signal is amplified by the Peak amplifier 24. The Peak amplifier 24 is powered by non-variable DC supply voltage.

At step s4, the amplified first component part of the input signal 21 is coupled to the output of the Peak amplifier using a second capacitor 29.

At step s5, the signals from the second capacitor 29 and the Peak amplifier 24 are summed.

At step s6, the summed signals are output from the modified Doherty amplifier 20.

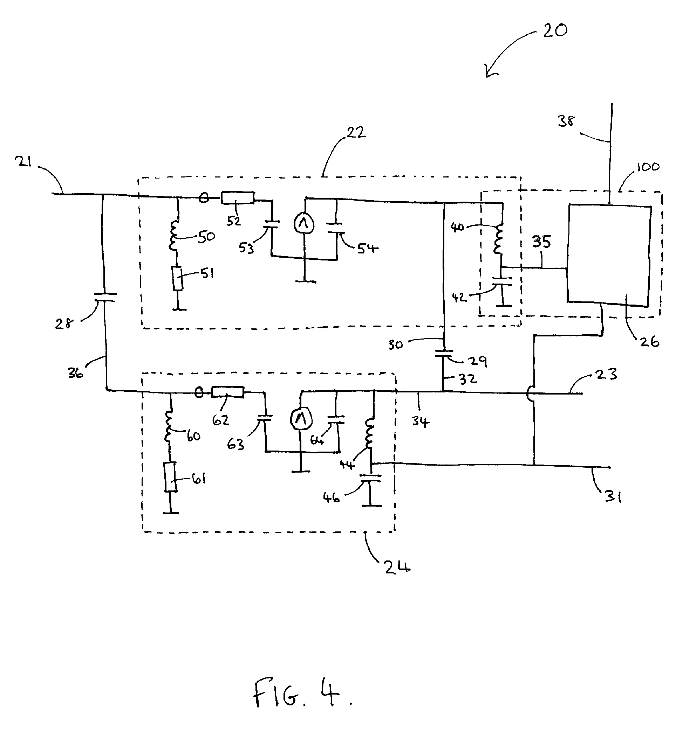

Figure 4 is a schematic illustration of the modified Doherty amplifier 20 of Figure 2 shown in greater detail.

The Main amplifier 22 comprises a first inductor 50, a second inductor 40, a first resistor 51, a second resistor 52, a first amplifier capacitor 53, a second amplifier capacitor 54 and a third amplifier capacitor 42.

A first terminal of the first inductor 50 receives the input signal 21. A second terminal of the first inductor 50 is connected to a first terminal of the first resistor 51. A second terminal of the first resistor 51 is connected to earth. A first terminal of the second resistor 52 receives the input signal 21. A second terminal of the second resistor 52 is connected to a first terminal of the first amplifier capacitor 53. A second terminal of the first amplifier capacitor 53 is connected to a first terminal of the second amplifier capacitor 54. A second terminal of the second amplifier capacitor 54 outputs the first output signal 30. The second terminal of the second amplifier capacitor 54 is connected to a first terminal of the second capacitor 29. The second terminal of the second amplifier capacitor 54 is connected to a first terminal of the second inductor 40. A second terminal of the second inductor 40 is connected to a first terminal of the third amplifier capacitor 42. A second terminal of the third amplifier capacitor 42 is connected to earth. The first terminal of the third amplifier capacitor 42 is connected to the modulator output 35.

The supply modulator 26 is arranged on the same die 100 as the third amplifier capacitor 42.

The Peak amplifier 24 comprises a third inductor 60, a fourth inductor 44, a third resistor 61, a fourth resistor 62, a fourth amplifier capacitor 63, a fifth amplifier capacitor 64 and a sixth amplifier capacitor 46.

A first terminal of the third inductor 60 receives the input signal 21. A second terminal of the third inductor 60 is connected to a first terminal of the third resistor 61. A second terminal of the third resistor 61 is connected to earth. A first terminal of the fourth resistor 62 receives the input signal 21. A second terminal of the fourth resistor 62 is connected to a first terminal of the fourth amplifier capacitor 63. A second terminal of the fourth amplifier capacitor 63 is connected to a first terminal of the fifth amplifier capacitor 64. A second terminal of the fifth amplifier capacitor 64 outputs the second output signal 34. The second terminal of the fifth amplifier capacitor 64 is connected to a first terminal of the fourth inductor 44. A second terminal of the fourth inductor 44 is connected to a first terminal of the sixth amplifier capacitor 46. A second terminal of the sixth amplifier capacitor 46 is connected to earth. The first terminal of the sixth amplifier capacitor 46 is connected to power supply 31.

The second inductor 40 and the third amplifier capacitor 42 comprise the LC Network, of the Main amplifier 22. The second inductor 40 is connected in parallel to the output of the Main amplifier 22. The second inductor 40 is connected to earth via the third amplifier capacitor 42 to avoid DC current through the second inductor 40.

The LC network of the Main amplifier 22 has the effect of partial detuning of the output parasitic capacitances of the Main amplifier 22 to achieve a required output impedance of the Main amplifier 22 and a required performance of the Doherty amplifier 20. The modulator output 35 is a signal comprising short pulses of constant length. The frequency of the short pulses of the modulator output 35 is proportional to the amplitude of the envelope of the input signal 21 and is above the frequency of the modulation signal. This has an advantage of avoiding interference, such as that caused by the short time of a rise and fall of power supply pulses due to integration of a low power modulator on the same die as a capacitor, where any electrical field or magnetic field radiation can be minimized, and which may become a cause of nonlinear distortions of a signal if it penetrates to the inputs of the Peak and Main amplifiers.

A further advantage is that of allowing the easier filtration of modulated supply harmonics.

A further advantage is that of requiring less capacitance in the LC Network of the Main amplifier 22 to suppress abrupt increases in the power supply.

A further advantage is that of creating more reliable, responsive and precise supply modulation due to a lower current amplitude being required to be controlled.

A further advantage is that the timing of all parallel supply modulators may be arranged with small time shift of the "On" and "Off" moments, which will have smoothing effect due to averaging.

The supply modulator 26 is controlled by a comparator (not shown). The comparator has two inputs. One of the comparator inputs receives the original envelope of the input signal 21. One of the comparator's inputs is connected the output of the supply modulator 26 and the third amplifier capacitor 42. This has the advantage of creating an automatically controlled feedback loop.

The modified Doherty amplifier system 20 and the method of modifying an input signal 21 using the modified Doherty amplifier 20, described in the embodiments above, have the advantage of requiring less power of power supply control than that required for Envelope Tracking Amplifiers.

A further advantage is that the low power supply modulator 26, which is coupled to the third amplifier capacitor 42, is coupled to the first output signal 30 via the second inductor 40. This allows the frequency of the Main amplifier drain, and/or collector, modulation to be extended up to 100MHz. This creates conditions for low signal distortions, which are similar in nature to the Electrical Memory effects, because the delay between the output of the supply modulator and the drain of the Main amplifier becomes much smaller.

A further advantage is that the modified Doherty amplifier system 20 consists of number of small integrated Doherty amplifiers arranged in parallel. Thus, switching noise can be minimised by randomising the "On" and "Off" switching time of supply modulators.

In the above embodiments, the input signal 21 is split unevenly between the Main amplifier 22 and the Peak amplifier 24 in the ratio defined in equation 1. However, in other embodiments the input signal may be split between the Main amplifier 22 and the Peak amplifier 24 in other ratios, for example, as defined in equation 2, or the input signal may be split between the Main amplifier 22 and the Peak amplifier 24 equally. The input signal 21 may be split between the Main amplifier 22 and the Peak amplifier 24 in a ratio that depends on the size of amplifiers 22, 24 and bias of Peak amplifier 24.

In the above embodiments, the amplifier output signal 21 is the sum of the first delayed output signal 32 and the second output signal 34. However, in other embodiments the amplifier output signal 21 can be other combinations of the first delayed output signal 32 and the second output signal 34.

In the above embodiments, the modulator output 35 is a variable DC supply voltage. The modulator output 35 is a signal comprising short pulses of constant length, the frequency of the short pulses is proportional to the amplitude of the envelope of the input signal 21. However, in other embodiments the modulator signal may take a different appropriate form, for example Delta modulation.

In the above embodiments, the supply modulator 26 is arranged on the same die 100 as the third amplifier capacitor 42, which is the capacitor of the LC network of the Main amplifier 22. However, in other embodiments the third amplifier capacitor 42 may be the output capacitance of the supply modulator and/or may be arranged on a different die or to be the capacitor located on the die of the Main amplifier.

In the above embodiments, the supply modulator 26 is a HBT switching device. However, in other embodiments the supply modulator 26 may be another appropriate type of device, for example a different type of high frequency switch modulator, for example a FET or LDMOS type switching device. In other embodiments, the supply modulator is a bistable structure or voltage controlled oscillator, where the switching element can be one or more transistors or diodes of any kind, oscillating or generating pulses at some particular frequency, and controlled and/or activated by a comparator device. In some embodiments, the comparator device has two inputs, a first input which receives a replica of the envelope of the input signal, and a second input connected to the third amplifier capacitor and/or the output of the integrated supply modulator. In other embodiments, the output of the comparator is connected to modulator input signal. In some embodiments, the comparator activates the supply modulator if its output voltage is below a certain threshold dependent upon the envelope replica of the modulator input signal, and deactivates the supply modulator if its output voltage is above a certain threshold dependent upon the envelope replica of the modulator input signal.

In the above embodiments, the supply modulator 26 provides minimal resistance when it is ON and high resistance when it is OFF. However, in another embodiment the supply modulator 26 may provide different levels of resistance in these states.

In the above embodiments, the input signal changes in time according to a modulation signal. The modulation signal frequency is significantly lower than the RF input signal. However, in other embodiments relationship between the modulation signal frequency and the input signal is different

In the above embodiments, the modulation frequency is below 100MHz. However, in other embodiments the modulation frequency is a different value, for example in other embodiments the modulation frequency is less than 20MHZ.

In the above embodiments, the supply modulator 26 is controlled by a comparator which creates an automatically controlled feedback loop. However, in other embodiments the supply modulator is not controlled by a comparator to create a feedback loop.

In the above embodiments, the Peak amplifier 24 and the supply modulator 26 are powered by a non-variable DC supply voltage. However, in other embodiments the Peak amplifier 24 and the supply modulator 26 may be powered by other appropriate means, for example, in other embodiments one, or both, of the Peak amplifier 24 and the supply modulator may be powered by variable DC supply voltages.

It will be appreciated that in the above embodiments the provided modified Doherty amplifiers, and methods of modifying an input signal, tend to extend the power range of the high efficiency operation of such a Doherty device without limitation. Also, in addition to the advantages outlined above, the above described systems and methods enable low power use and wideband high-speed supply voltage control in high-power Integrated Doherty (ID) devices comprising a number of small Doherty cells, for example an ID device comprising up to 20 ID cells arranged in parallel, if every cell has its own supply modulator connected through the cell's LC Network.

**Claims**

1.  An amplifier system (20) comprising:

    a main amplifier (22);
    a peak amplifier (24); wherein
    the main amplifier (22) is adapted to output an amplified signal (30);
    the main amplifier (22) is powered by a variable supply voltage (35);
    the main amplifier (22) comprises an inductor (40) and a capacitor (42) connected in series;
    the inductor (40) is connected to earth via the capacitor (42); and
    the variable supply voltage (35) is connected to the main amplifier output signal (30) via the inductor (40).

2.  A system according to claim 1, further comprising a supply modulator (26); wherein
    the variable supply voltage (35) is the output from the supply modulator (26);
    the amplifier system (20) is adapted to receive a first input signal (21); the supply modulator (26) is adapted to receive a second input signal (38); and
    the second input signal (38) is the envelope of a replica of the first input signal (21).

3.  A system according to claim 2, wherein the variable supply voltage (35) is the amplified envelope of a replica of the first input signal (21).

4.  A system according to claim 2 or 3, wherein:

    the inductor (40) and the capacitor (42) are arranged in parallel to the main amplifier output signal (30).

5.  A system according to claim 4, wherein the supply modulator (26) and the capacitor (42) are arranged on the same die.

6.  A system according to any of claims 2 to 5, wherein the supply modulator (26) is an HBT switching device.

7.  A system according to any of claims 1 to 6, wherein:

the peak amplifier (24) is adapted to output an amplified signal (34); and
the amplifier system is adapted to combine the main amplifier output signal (30) and the peak amplifier output signal (34).

8.  A method of modifying a signal comprising the steps of:

    splitting the input signal (21) into a first component signal and a second component signal;
    amplifying the first component signal with a main amplifier (22); and
    amplifying the second component signal with a peak amplifier (24); wherein
    the main amplifier (22) is adapted to output an amplified signal (30);
    the main amplifier (22) is powered by a variable supply voltage (35);
    the main amplifier (22) comprises an inductor (40) and a capacitor (42) connected in series;
    the inductor (40) is connected to earth via the capacitor (42); and
    the variable supply voltage (35) is connected to the main amplifier output signal (30) via the inductor (40).

9.  A method of modifying a signal according to claim 8, further comprising the steps of:

    delaying the second component signal;
    delaying the amplified first component signal; and
    recombining the delayed amplified first component signal and the amplified second component signal.

10. A method of modifying a signal according to claim 9, wherein:

    the variable supply voltage (35) is the output from a supply modulator (26); and
    the variable supply voltage (35) is the amplified envelope of a replica of the first input signal (21).

11. A method of modifying a signal according to claim 10, wherein:

    the inductor (40) and the capacitor (42) are arranged in parallel to the main amplifier output signal (30).

12. A method of modifying a signal according to any of claims 10 or 11 wherein the supply modulator (26) and the capacitor (42) are arranged on the same die.

13. A method according to any of claims 9 to 12 wherein the supply modulator (26) is an HBT switching device.

14. A method according to any of claims 8 to 13, wherein:

    the peak amplifier (24) outputs an amplified signal (34); and
    the main amplifier output signal (30) and the peak amplifier output signal (34) are combined.

FIG 1   PRIOR ART

FIG. 2

START — s1

SPLIT INPUT

FIRST INPUT COMPONENT INPUT TO MAIN AMP. — s2
SECOND INPUT COMPONENT INPUT TO PEAK AMP.

FIRST INPUT COMPONENT AMPLIFIED AND — s3
OUTPUT BY MAIN AMP.

SECOND INPUT COMPONENT AMPLIFIED AND
OUTPUT BY PEAK AMP

MAIN AMP IS POWERED BY VARIABLE
SUPPLY VOLTAGE PROPORTIONATE
TO INPUT ENVELOPE

OUTPUT OF MAIN AMP IS COUPLED — s4
TO OUTPUT OF PEAK AMP

COUPLED OUTPUT OF MAIN AMP — s5
AND OUTPUT OF PEAK AMP ARE
SUMMED

SUMMED SIGNAL IS OUTPUT — s6

END

FIG. 3

FIG. 4.

# EP 2 267 885 A1

Europäisches
Patentamt

European
Patent Office

Office européen
des brevets

## EUROPEAN SEARCH REPORT

Application Number

EP 09 16 2964

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JINSUNG CHOI ET AL: "Optimized Envelope Tracking Operation of Doherty Power Amplifier for High Efficiency Over an Extended Dynamic Range" IEEE TRANSACTIONS ON MICROWAVE THEORY AND TECHNIQUES, IEEE SERVICE CENTER, PISCATAWAY, NJ, US, vol. 57, no. 6, 1 June 2009 (2009-06-01), pages 1508-1515, XP011257253 ISSN: 0018-9480 * page 1511, right-hand column - page 1512, left-hand column; figures 3,7,8 * | 1-4, 6-11,13, 14 | INV. H03F1/02 |
| Y | US 6 049 703 A (STAUDINGER JOSEPH [US] ET AL) 11 April 2000 (2000-04-11) * column 4, line 1 - line 10; figures 7,8 * | 1-14 | |
| Y | WO 2007/122586 A (KONINKL PHILIPS ELECTRONICS NV [NL]; BLEDNOV IGOR [NL] NXP BV [NL]; BL) 1 November 2007 (2007-11-01) * page 9, line 14 - line 28; figure 6 * | 1-14 | |
| Y | EP 1 677 414 A (POSTECH FOUNDATION [KR]) 5 July 2006 (2006-07-05) * figure 14 * | 1-14 | TECHNICAL FIELDS SEARCHED (IPC) H03F |
| Y | US 2005/264364 A1 (SELIN JOHN R [US]) 1 December 2005 (2005-12-01) * paragraph [0026]; figure 3 * | 1-14 | |
| Y | EP 1 492 228 A (NORTHROP GRUMMAN CORP [US]) 29 December 2004 (2004-12-29) * figure 3 * | 1-14 | |
| Y | WO 98/56107 A (MOTOROLA INC [US]) 10 December 1998 (1998-12-10) * figure 3 * | 1-14 | |

-/--

The present search report has been drawn up for all claims

| Place of search | Date of completion of the search | Examiner |
|---|---|---|
| Munich | 16 October 2009 | Kurzbauer, Werner |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

13

Europäisches
Patentamt

European
Patent Office

Office européen
des brevets

# EUROPEAN SEARCH REPORT

Application Number

EP 09 16 2964

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2008/013481 A (ERICSSON TELEFON AB L M [SE]; HELLBERG RICHARD [SE]; FONDEN TONY [SE]) 31 January 2008 (2008-01-31) * figures 9,13 * | 1-14 | |
| A | WO 02/15387 A (ERICSSON INC [US]; DENT PAUL W [US]; CAMP WILLIAM O JR [US]) 21 February 2002 (2002-02-21) * figures 20,21 * | 1-14 | |
| A | YONG-SUB LEE ET AL: "Highly Linear Power Tracking Doherty Amplifierfor WCDMA Repeater Applications" IEEE MICROWAVE AND WIRELESS COMPONENTS LETTERS, IEEE SERVICE CENTER, NEW YORK, NY, US, vol. 18, no. 7, 1 July 2008 (2008-07-01), pages 485-487, XP011227726 ISSN: 1531-1309 * page 486, left-hand column; figure 1 * | 1-14 | |

TECHNICAL FIELDS
SEARCHED        (IPC)

The present search report has been drawn up for all claims

| Place of search | Date of completion of the search | Examiner |
|---|---|---|
| Munich | 16 October 2009 | Kurzbauer, Werner |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**  EP 09 16 2964

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2009

| Patent document cited in search report | | Publication date | Patent family member(s) | | Publication date |
|---|---|---|---|---|---|
| US 6049703 | A | 11-04-2000 | NONE | | |
| WO 2007122586 | A | 01-11-2007 | EP | 2013943 A2 | 14-01-2009 |
| | | | US | 2009174482 A1 | 09-07-2009 |
| EP 1677414 | A | 05-07-2006 | CN | 1822492 A | 23-08-2006 |
| | | | JP | 2006191590 A | 20-07-2006 |
| | | | KR | 20060077818 A | 05-07-2006 |
| | | | US | 2006145757 A1 | 06-07-2006 |
| US 2005264364 | A1 | 01-12-2005 | EP | 1749342 A1 | 07-02-2007 |
| | | | JP | 2008500778 T | 10-01-2008 |
| | | | KR | 20070015190 A | 01-02-2007 |
| | | | WO | 2005119903 A1 | 15-12-2005 |
| EP 1492228 | A | 29-12-2004 | JP | 2005020694 A | 20-01-2005 |
| | | | US | 2004263246 A1 | 30-12-2004 |
| WO 9856107 | A | 10-12-1998 | US | 6097252 A | 01-08-2000 |
| WO 2008013481 | A | 31-01-2008 | EP | 2044687 A1 | 08-04-2009 |
| WO 0215387 | A | 21-02-2002 | AU | 7911301 A | 25-02-2002 |
| | | | CN | 1493106 A | 28-04-2004 |
| | | | CN | 1893258 A | 10-01-2007 |
| | | | EP | 1364456 A2 | 26-11-2003 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7330071 B

- WO 2007119208 A

### Non-patent literature cited in the description

- **Frederick H. Raab.** EFFICIENCY OF DOHERTY RF POWER-AMPLIFIER SYSTEMS. *IEEE TRANSACTIONS ON BROADCASTING,* September 1987, vol. BC-33 (3

- **J. Choi ; D. Kang ; D. Kim ; B. Kim.** Optimized Envelope Tracking Operation of Doherty Power Amplifier for High Efficiency Over an Extended Dynamic Range. *IEEE Transactions on Microwave Theory and Techniques,* 2009